## Europäisches Patentamt

## European Patent Office

## Office européen des brevets

(11) Veröffentlichungsnummer: **0 112 509**
A2

# (12) EUROPÄISCHE PATENTANMELDUNG

(21) Anmeldenummer: 83111832.8

(22) Anmeldetag: 25.11.83

(51) Int. Cl.³: **G 03 F 1/00**

(30) Priorität: 11.12.82 DE 3245868

(43) Veröffentlichungstag der Anmeldung: 04.07.84
Patentblatt 84/27

(84) Benannte Vertragsstaaten: **AT BE CH DE FR GB IT LI LU NL SE**

(71) Anmelder: **EUROSIL electronic GmbH, Erfurter Strasse 16, D-8057 Eching (DE)**

(72) Erfinder: **Fischer, Gerhard, Dr., Johann-Schmid-Strasse 25, D-8044 Unterschleissheim (DE)**

(74) Vertreter: **Schaumburg, Schulz-Dörlam & Thoenes, Mauerkircherstrasse 31 Postfach 86 07 48, D-8000 München 86 (DE)**

(54) **Thermisch unempfindliche Bestrahlungsmaske für Röntgenlithographie und Verfahren zur Herstellung derartiger Masken.**

(57) Bei herkömmlichen Bestrahlungsmasken für die Röntgenlithographie, die aus einer Trägerschicht und einer einseitig aufgebrachten Absorberstruktur bestehen, findet durch die während der Belichtung auftretende Erwärmung infolge der unterschiedlichen Wärmeausdehnungskoeffizienten von Träger- und Absorbermaterial eine Verbiegung der Bestrahlungsmaske statt (Bimetalleffekt). Bei der erfindungsgemäßen, thermisch unempfindlichen Bestrahlungsmaske wird dagegen die Absorberstruktur 102, 103 bezüglich ihrer Schichtdicke symmetrisch zur Schichtmitte 106 der Trägerschicht 101 aufgebracht, so daß sich die durch die Erwärmung auftretenden Kräfte hinsichtlich des Biegemomentes selbst kompensieren.

Thermisch unempfindliche Bestrahlungsmaske für Röntgenlithographie und Verfahren zur Herstellung derartiger
Masken

---

Die vorliegende Erfindung betrifft eine thermisch unempfindliche Bestrahlungsmaske für Röntgenlithographie
gemäß dem Oberbegriff des Anspruches 1.

Derartige Bestrahlungsmasken für die Röntgenlithographie
sind bekannt.

So ist zum Beispiel aus der DE-AS 23 02 116 eine Bestrahlungsmaske für die Röntgenlithographie entnehmbar,
wobei weiche Röntgenstrahlung im Wellenlängenbereich
zwischen 2 und 100 Å verwendet werden soll. Die Bestrahlungsmaske besteht dabei aus einer für die weiche
Röntgenstrahlung durchlässigen Schicht aus etwa 5 µm
dicken Silizium, Magnesium, Beryllium oder Mylar,
sowie aus einer, die weiche Röntgenstrahlung absorbierenden Schicht mit einer Dicke von etwa 0,5 µm.
Die absorbierende Schicht kann dabei aus Kupfer, Silber,
Gold oder Uran bestehen. Die absorbierende Schicht wird
dabei entsprechend der mittels der Belichtung durch die
weiche Röntgenstrahlung auf einem röntgenstrahlenempfindlichen Substrat zu erzeugenden Strukturen in
einem geeigneten Positiv- oder Negativmuster aufgebracht.

... 2

0112509

Weiterhin ist aus der DE-PS 23 46 719 eine mehrschichtige Bestrahlungsmaske für die Röntgenlithographie entnehmbar. Diese Maske besteht aus einem Siliziumkörper, der auf der einen Breitseite seiner Oberfläche mit einer Trägerschicht belegt ist. Die Trägerschicht besteht dabei aus einer $SiO_2$ - Schicht und einer Stützschicht aus Polyimid. Dabei weist die Stützschicht eine Dicke zwischen 3 und 10 µm und die $SiO_2$ - Schicht eine Dicke von etwa 5 µm auf. Auf der Stützschicht werden die maskierenden Strukturen aus röntgenabsorbierenden Material, z. B. aus Gold aufgebracht. Der Siliziumkörper wird an den Stellen, an denen sich die maskierenden Strukturen befinden, selektiv bis zur $SiO_2$ - Schicht abgeätzt. Durch die so entstandenen Fenster kann nun die Belichtung mittels Röntgenstrahlung erfolgen.

Wie sich aus dem Vorstehenden ergibt, werden in der Bestrahlungsmaske die Röntgenstrahlen teilweise absorbiert. Durch eine derartige Absorption der Strahlungsenergie wird nunmehr die Bestrahlungsmaske während der Belichtung erwärmt. Da die Maske aus mindestens zwei unterschiedlichen Materialien, nämlich dem Träger aus strahlungsdurchlässigem Material und der Absorberstruktur aus strahlungsundurchlässigem Material besteht, welche bei den hier verwendeten Materialien einen deutlich unterschiedlichen Wärmeausdehnungskoeffizienten aufweisen, tritt bei einer Erwärmung ein deutlich ausgeprägter Bimetalleffekt auf. Dies bedeutet, daß sich die Bestrahlungsmaske während des Belichtungsvorganges verbiegt, was außerordentlich negative Auswirkungen auf die Qualität der Belichtung hat.

Um diesen Bimetalleffekt der Bestrahlungsmaske zu verringern, kann, wie in der bereits obengenannten DE-PS 23 46 719 vorgeschlagen, der Träger durch die mehrschichtige Ausbildung mechanisch fester und gegen thermische Beanspruchung beständiger ausgelegt werden. Dadurch ergibt sich jedoch eine größere Dicke des Trägers, die zu einer verstärkten Absorption im Träger und damit zu einer Verringerung des Abbildungskontrastes führt.

Demgegenüber ist es Aufgabe der vorliegenden Erfindung, eine Bestrahlungsmaske für Röntgenlithographie vorzuschlagen, welche sich bei Erwärmung nicht oder nur vernachlässigbar verbiegt und welche weiterhin einen hohen Abbildungskontrast erlaubt. Außerdem soll die Defektdichte in der maskierenden Struktur verringert werden. Weiterhin ist es Aufgabe der vorliegenden Erfindung, Verfahren zur Herstellung derartiger Masken vorzuschlagen.

Zur Lösung dieser Aufgabe wird eine Bestrahlungsmaske gattungsgemäßer Art entsprechend dem Kennzeichen des Anspruches 1 ausgestaltet.

Der besondere Vorteil dieser Lösung liegt darin, daß sich durch die symmetrische Anordnung der Absorberstruktur bezüglich der Trägerschicht die bei einer Erwärmung der Bestrahlungsmaske infolge der unterschiedlichen Wärmeausdehnungskoeffizienten von Absorberstruktur und Trägerschicht auftretenden Kräften hinsichtlich eines Biegemomentes selbst kompensieren. Das bedeutet, daß kein Bimetalleffekt, der zu einer Verbiegung der Bestrahlungsmaske führen könnte, auftritt.

- 4 -

Weitere Vorteile sind den Unteransprüchen entnehmbar:

Wo wird durch die Anordnung je einer Hälfte der Absorberstruktur auf den beiden Schichtseiten der Trägerschicht in vorteilhafter Weise eine Reduzierung der Defektdichte erreicht, da es unwahrscheinlich ist, daß Defekte in der Absorberstruktur auf beiden Schichtseiten an der gleichen Stelle auftreten.

Die verschiedenen Herstellungsverfahren für die erfindungsgemäße Bestrahlungsmaske erlauben durch die Verwendung der Absorberstruktur auf der einen Schichtseite für die Herstellung der zweiten Absorberstruktur auf der anderen Schichtseite eine präzise Übereinstimmung der beiden Absorberstrukturen ohne besondere Markierungs- oder Einstellungsverfahren.

Durch die Verwendung von weicher Röntgenstrahlung für die Übertragung der Absorberstruktur von der einen auf die andere Schichtseite wird in vorteilhafter Weise eine sehr genaue Reproduktion auch feinster Strukturen sichergestellt.

Im folgenden soll nun anhand der Figuren der Zeichnung die Erfindung näher erläutert werden. Im Einzelnen zeigt die Zeichnung in

Fig. 1   ein Ausführungsbeispiel der erfindungsgemäßen Bestrahlungsmaske im Querschnitt,

Fig. 2   die einzelnen Schritte (a) bis (f) eines Herstellungsverfahrens für eine thermisch unempfindliche Bestrahlungsmaske,

Fig. 3　die einzelnen Schritte (a) bis (f) eines weiteren Herstellungsverfahrens für eine thermisch unempfindliche Bestrahlungsmaske,

Fig. 4　die einzelnen Schritte (a) bis (g) eines dritten Herstellungsverfahrens für eine thermisch unempfindliche Bestrahlungsmaske.

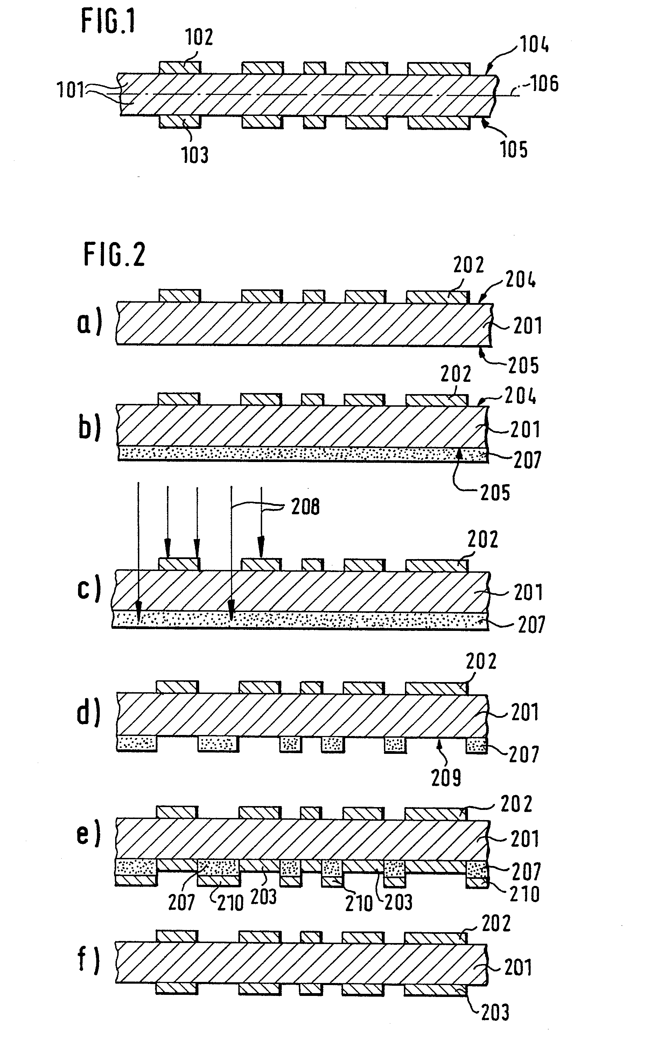

In Fig. 1 ist eine thermisch unempfindliche Bestrahlungsmaske für Röntgenlithographie im Querschnitt dargestellt. Dabei ist nur ein Ausschnitt aus der eigentlichen Bestrahlungsmaske dargestellt, da die anderen Teile, wie zum Beispiel ein Trägerkörper zur mechanischen Stabilisierung der Maske, für die Erfindung unwesentlich sind.

Die erfindungsgemäße Bestrahlungsmaske besteht aus einer Trägerschicht 101 und einer auf derselben mechanisch fixierten Absorberstruktur 102, 103. Die Absorberstruktur 102, 103 ist bezüglich ihrer Schichtdicke in zwei Teilstrukturen aufgeteilt. Dabei ist der eine Teil der Absorberstruktur 102 auf der einen Schichtseite 104 und der andere Teil der Absorberstruktur 103 auf der anderen Schichtseite 105 der Trägerschicht 101 angeordnet. Die Dicke der beiden Teile der Absorberstruktur 102, 103 ist ungefähr gleich; die Geometrie der beiden Teile der Absorberstruktur 102, 103 ist spiegelbildlich identisch, d.h., die beiden Strukturen überdecken sich gegenseitig exakt. Somit ist die Absorberstruktur 102, 103 symmetrisch zu einer Ebene durch die Schichtmitte 106 der Trägerschicht 101.

Diese Symmetrie ist notwendig, um die thermische Unempfindlichkeit zu erreichen: Da die Bestrahlungsmaske notwendigerweise aus mindestens zwei unterschiedlichen Materialien aufgebaut sein muß - die Trägerschicht 104 muß möglichst durchlässig für die bevorzugt angewendete weiche Röntgenstrahlung im Wellenlängenbereich zwischen 2 und 100 Å sein, während die Absorberschicht 102, 103 die gleiche Röntgenstrahlung möglichst gut absorbieren soll - ergeben sich bei der zwangsläufigen Erwärmung der Bestrahlungsmaske durch die Absorption von Röntgenstrahlung aufgrund der unterschiedlichen Wärmeausdehnungskoeffizienten Kräfte, die auf die Bestrahlungsmaske einwirken. Bei einer unsymmetrischen Anordnung der Absorberstruktur 102, 103 auf der Trägerschicht 101 wirken auf beiden Schichtseiten 104, 105 unterschiedliche Kräfte, was zu einer erheblichen Verbiegung der Trägerschicht 101 und damit der gesamten Maske führen kann (Bimetalleffekt). Durch die symmetrische Anordnung der Absorberstruktur 102, 103 bezüglich der Schichtmitte 106 der Trägerschicht 101 kompensieren sich bei einer Erwärmung auftretenden Kräfte hinsichtlich des Biegemomentes.

Die Absorberstruktur 102, 103 besteht vorzugsweise aus einem der Metalle Gold, Platin, Silber, Uran, Kupfer oder Wolfram mit einer Gesamtdicke von etwa 0,5 μm. Bei einer symmetrischen Absorberstruktur 102, 103, die bezüglich ihrer Schichtdicke je zur Hälfte auf den beiden Schichtseiten 104, 105 der Trägerschicht 101 aufgebracht ist, weist demnach jeder Teil der Absorberstruktur 102, 103 eine Dicke von etwa 0,25 μm auf.

Durch die Aufteilung der Absorberstruktur 102, 103 in zwei Teilstrukturen verringert sich die Fehlerdichte bei einer derartigen Bestrahlungsmaske erheblich. Dies liegt daran, daß bestimmte Fehler (z. B. pinholes u.ä.), welche im Material der Absorberstruktur 102, 103 auftreten, mit großer Wahrscheinlichkeit nicht in beiden Teilen der Absorberstruktur 102, 103 an der gleichen Stelle auftreten, so daß eine ausreichende Absorption an diesen Fehlerstellen meist im jeweils anderen Teil der Absorberstruktur 102, 103 stattfindet.

Die Trägerschicht 101 besteht vorzugsweise aus einem oder mehreren der Materialien Silizium, Siliziumnitrid, Siliziumoxinitrid oder aber aus einer Kunststoffolie, wie z. B. Mylar, oder Polyimid, wobei die Kunststoffolie auch mit einem der anderen Materialien kombiniert sein kann. Die Dicke der Trägerschicht 101 liegt zwischen etwa 0,5 und 15 $\mu$m, wobei geringere Dicken eine bessere Auflösung der mittels der Bestrahlungsmaske hergestellten Strukturen ergeben.

Im folgenden werden nun verschiedene Herstellungsverfahren für eine thermisch unempfindliche Bestrahlungsmaske der im Vorstehenden beschriebenen Art näher erläutert. Dabei wird jeweils davon ausgegangen, daß der eine Teil der Absorberstruktur 102 auf der einen Schichtseite 104 der Trägerschicht 101 bereits vorhanden ist. Zur Herstellung dieses einen Teils der Absorberstruktur 102 kann eines der verschiedenen bekannten Verfahren verwendet werden, wie z. B. Elektronenstrahllithographie oder wie der DE-AS 23 02 116 entnehmbar.

Die Fig. 2 zeigt im Teil (a) eine derartige einseitig beschichtete Bestrahlungsmaske mit einer Trägerschicht 201 mit den beiden Schichtseiten 204, 205, wobei auf die eine Schichtseite 204 bereits ein Teil der Absorberstruktur 202 aufgebracht ist. Auf die andere Schichtseite 205 der Trägerschicht 201 wird eine lichtempfindliche Schicht 207 aus Photonegativ-Lack aufgebracht (Fig. 2 b), welche vorzugsweise für weiche Röntgenstrahlung im Wellenlängenbereich 2 bis 100 Å empfindlich ist. Im nächsten Verfahrensschritt (Fig. 2c) wird die lichtempfindliche Schicht 207 mittels elektromagnetischer Strahlung, vorzugsweise weicher Röntgenstrahlung im Wellenlängenbereich zwischen 2 und 100 Å belichtet. In Fig. 2 c ist diese Strahlung mittels Pfeilen 208 angedeutet. Die Einfallsrichtung dieser elektromagnetischen Strahlung liegt senkrecht zur Trägerschicht 201 durch die eine Schichtseite 204, so daß der bereits vorhandene eine Teil der Absorberstruktur 202 als Bestrahlungsmaske für die lichtempfindliche Schicht 207 wirkt. Nach der Belichtung wird die lichtempfindliche Schicht 207 entwickelt. Nachdem Photonegativ-Lack verwendet ist, bleibt die entwickelte lichtempfindliche Schicht 207 an den belichteten Stellen stehen und an den unbelichteten Stellen ergeben sich Aussparungen 209, wie in Fig. 2 d dargestellt. Die Aussparungen 209 entsprechen in ihrer Struktur exakt der einen Absorberstruktur 202. Danach wird eine Schicht aus Absorbermaterial 210 z. B. durch Aufdampfen im Vakuum oder durch Aufsputtern aufgebracht (Fig 2 e). Diese Schicht bedeckt in gleichmäßiger Dicke sowohl die stehengebliebenen Teile der entwickelten lichtempfindlichen Schicht 207 als auch die Trägerschicht 201 in den Aussparungen 209. Das in den Aussparungen 209 aufgebrachte Absorbermaterial 210 bildet dort nach der Entfernung der stehengebliebenen Teile der lichtempfindlichen Schicht 207 zusammen mit dem darauf aufgebrachten Absorbermaterial 210 (in Lift-off-Technik)
den anderen Teil der Absorberstruktur 203 (Fig. 2f).

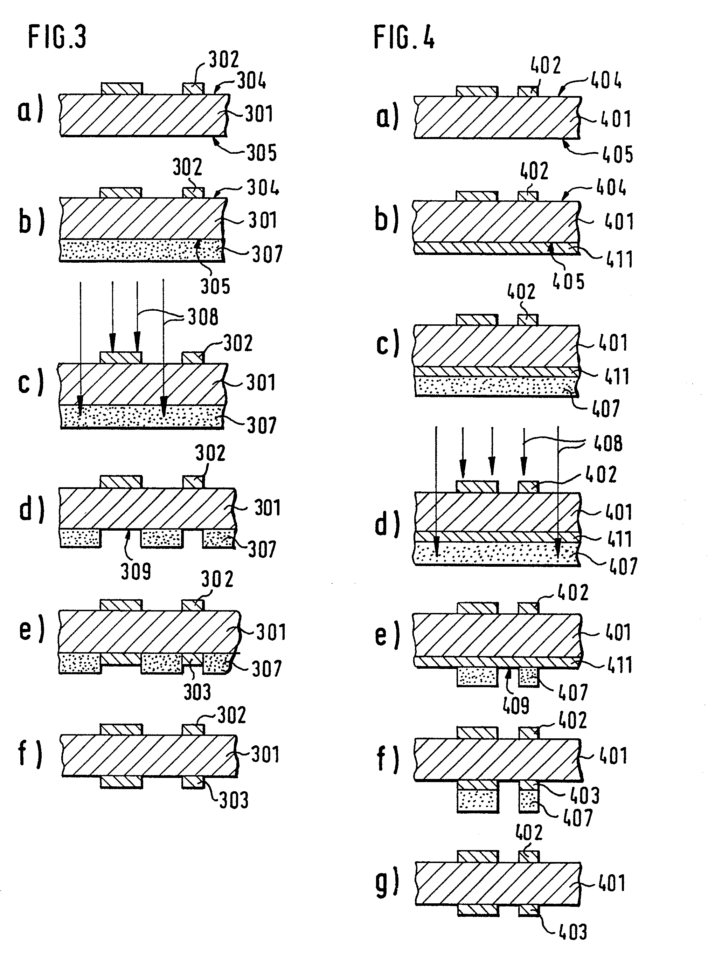

Die Fig. 3 zeigt im Teil (a) ebenso wie Fig. 2 a eine
einseitig mit einem Teil der Absorberstruktur 302 versehene Trägerschicht 301 mit den beiden Schichtseiten
304, 305. Auf die zweite Schichtseite 305 wird eine
lichtempfindliche Schicht 307 aus Photonegativ-Lack aufgebracht (Fig. 3 b). Diese lichtempfindliche Schicht 307
wird, analog wie bei Fig. 2 c, unter Verwendung des auf
einer Schichtseite 305 bereits vorhandenen einen Teils
der Absorberstruktur 302 als Bestrahlungsmaske belichtet.
Dies ist in Fig. 3c dargestellt, wobei die belichtende
Strahlung duch Pfeile 308 angedeutet ist. Nach der Entwicklung der lichtempfindlichen Schicht 307 entstehen
an den unbelichteten Stellen Aussparungen 309 in der
Schicht 307 (Fig. 3d). Diese Aussparungen 309 entsprechen in ihrer Lage dem bereits vorhandenen einen
Teil der Absorberstruktur 302. In den Aussparungen 309
kann nun der andere Teil der Absorberstruktur 303
galvanisch direkt aufgebracht werden (Fig. 3 e), so
daß nur noch der stehengebliebene Teil der entwickelten lichtempfindlichen Schicht 307 entfernt werden muß, so daß dann die Bestrahlungsmaske aus der
Trägerschicht 301 und den beiden Absorberstrukturen
302, 303 vorliegt (Fig. 3 f). Dieses letztere Verfahren
wird vorzugsweise bei elektrisch leitfähigen Trägerschichten 301 angewendet, da das galvanische Aufbringen
der zweiten Absorberstruktur 303 einfacher und kostengünstiger durchgeführt werden kann als das Aufdampfen
oder Aufsputtern nach dem Verfahren nach Fig. 2.

In Fig. 4 sind die einzelnen Schritte eines dritten Herstellungsverfahrens für eine thermisch unempfindliche Bestrahlungsmaske dargestellt. Fig. 4 a zeigt, ebenso wie bei beiden vorangegangenen Verfahren, eine auf der einen Schichtseite 404 mit einem Teil der Absorberstruktur 402 belegten Trägerschicht 401, während die andere Schichtseite 405 noch frei ist. Auf diese freie Schichtseite 405 wird im ersten Verfahrensschritt eine Schicht aus Absorbermaterial 411 aufgebracht (Fig. 4 b). Die Aufbringung dieses Absorbermaterials 411 kann auf verschiedenen üblichen Wegen geschehen, wie z. B. Aufdampfen, Aufsputtern oder galvanisch. Auf dieses Absorbermaterial 411 wird im nächsten Verfahrensschritt eine lichtempfindliche Schicht 407 aufgebracht, welche aus Photopositiv-Lack besteht (Fig. 4 c). Danach wird die lichtempfindliche Schicht 407 analog wie bei Fig. 2 belichtet. Dies ist in Fig. 4 d dargestellt, wobei die elektromagnetische Strahlung mit Pfeilen 408 angedeutet ist. Bei diesem Verfahren ergeben sich gewisse Probleme mit der Belichtung der lichtempfindlichen Schicht 407, da die Belichtung durch das Absorbermaterial 411 hindurch erfolgen muß. Ein Kontrast von etwa 3 : 1 zwischen den belichteten Stellen (Durchstrahlung von Trägerschicht 401 und Absorbermaterial 411) und den unbelichteten Stellen (Durchstrahlung des einen Teils der Absorberstruktur 402, der Trägerschicht 401 und des Absorbermaterials) ist jedoch bei einer Dicke von 0,25 μm sowohl des einen Teils der Absorberstruktur 402 als auch des Absorbermaterials 411 erreichbar und auch ausreichend. Im nächsten Verfahrensschritt (Fig. 4 e) wird die lichtempfindliche Schicht 407 entwickelt. Da hier Photopositiv-Lack verwendet wird, ergeben sich Aussparungen 409 in der entwickelten lichtempfindlichen Schicht 407 an den belichteten Stellen. Danach wird das Absorbermaterial 411 in den Aussparungen 409 in bekannter Ätztechnik entfernt (Fig. 4 f), und nach dem Ätzen auch der stehengebliebene Teil des entwickelten lichtempfindlichen Materials 407 (Fig. 4 g). Danach liegt wieder die Bestrahlungsmaske aus der Trägerschicht 401 und den beiden spiegelbildlich identischen Teilen der Absorberstruktur 402, 403 vor.

Die drei, im Vorstehenden beschriebenen Verfahren zur Herstellung einer thermisch unempfindlichen Bestrahlungsmaske weisen den gemeinsamen Vorteil auf, daß zur Erzeugung des anderen Teils der Absorberstruktur 103, 203, 303 403 jeweils der bereits vorhandene Teil der Absorberstruktur 102, 202, 302, 402 verwendet wird. Durch diese Maßnahme ergibt sich ohne Einstell- oder Justierungsvorgänge direkt die exakte gegenseitige Überdeckung beider Absorberstrukturen 102, 103; 202, 203; 302, 303; 402, 403; so daß der zusätzliche Herstellungsaufwand der erfindungsgemäßen Bestrahlungsmaske gegenüber herkömmlichen Bestrahlungsmasken relativ gering ist.

## Patentansprüche

1. Thermisch unempfindliche Bestrahlungsmaske für Röntgenlithographie aus einer dünnen Trägerschicht aus strahlungsdurchlässigem Material und aus einer dünnen Absorberstruktur aus strahlungsabsorbierendem Material, welches durch die Trägerschicht mechanisch fixiert ist,
dadurch gekennzeichnet,
daß die Absorberstruktur (102, 103; 202, 203; 302, 303; 402, 403) symmetrisch zu einer Ebene durch die Schichtmitte (106) der Trägerschicht (101; 201; 301; 401) angeordnet ist.

2. Thermisch unempfindliche Bestrahlungsmaske nach Anspruch 1,
dadurch gekennzeichnet,
daß die Absorberstruktur (102, 103; 202, 203; 302, 303; 402, 403) bezüglich ihrer Schichtdicke je etwa zur Hälfte auf beiden Schichtseiten (104, 105; 204, 205; 304, 305; 404, 405) der Trägerschicht (101; 201; 301; 401) angeordnet ist.

3.. Thermisch unempfindliche Bestrahlungsmaske nach Anspruch 1 oder 2,
dadurch gekennzeichnet,
daß die auf beiden Schichtseiten (104, 105; 204, 205; 304, 305; 404, 405) angeordneten Teile der Absorberstruktur (102, 103; 202, 203, 302, 303; 402, 403) bezüglich ihrer Geometrie spiegelbildlich identisch sind.

4. Thermisch unempfindliche Bestrahlungsmaske nach einem der Ansprüche 1 bis 3, dadurch gekennzeichnet, daß die Absorberstruktur (102, 103; 202, 203; 302, 303; 402, 403) aus einem oder mehreren der Metalle Gold, Platin, Silber, Uran, Kupfer oder Wolfram mit einer Gesamtschichtdicke von etwa 0,5 μm besteht.

5. Thermisch unempfindliche Bestrahlungsmaske nach mindestens einem der Ansprüche 1 bis 4, dadurch gekennzeichnet, daß die Trägerschicht (101; 201; 301; 401) aus einem oder mehreren der Materialien Silizium, Siliziumnitrid, Siliziumoxinitrid und aus Kunststofffolie mit einer Dicke zwischen etwa 0,5 und 15 μm be- steht.

6. Verfahren zur Herstellung einer thermisch unempfindlichen Bestrahlungsmaske nach mindestens einem der Ansprüche 1 bis 5, dadurch gekennzeichnet, daß auf der einen Schichtseite ( 204; 304) der Trägerschicht (201; 301) eine erste Absorberstruktur (202; 302) nach einem üblichen Verfahren aufgebracht wird, daß auf der anderen Schichtseite (205; 305) der Trägerschicht (201; 301) eine lichtempfindliche Schicht (207; 307) aufgebracht wird, welche unter Benutzung der ersten Absorberstruktur (202; 302) auf der einen Schichtseite (204; 304) als Bestrahlungsmaske belichtet wird, daß die lichtempfindliche Schicht (207; 307) entwickelt wird und danach auf der anderen Schichtseite eine zweite Absorberstruktur (203;303) aufgebracht wird, welche bezüglich Dicke, Form und Lage identisch mit der ersten Absorberstruktur (202; 302) ist.

7. Verfahren zur Herstellung einer thermisch unempfindlichen Bestrahlungsmaske nach mindestens einem der Ansprüche 1 bis 5,
dadurch gekennzeichnet,
daß auf der einen Schichtseite (404) der Trägerschicht (401) eine erste Absorberstruktur (402) nach einem üblichen Verfahren aufgebracht wird, daß auf der anderen Schichtseite (405) eine durchgehende Absorberschicht (411) und darauf eine lichtempfindliche Schicht (407) aufgebracht wird, welche lichtempfindliche Schicht (407) unter Benutzung der ersten Absorberstruktur (402) auf der einen Schichtseite (404) als Bestrahlungsmaske belichtet wird, daß die lichtempfindliche Schicht (407) entwickelt wird und danach ein Teil der durchgehenden Absorberschicht (411) entfernt wird, so daß eine zweite Absorberstruktur (403) entsteht, welche bezüglich Dicke, Form und Lage identisch mit der ersten Absorberstruktur (402) ist.

8. Verfahren nach einem der Ansprüche 6 oder 7,
dadurch gekennzeichnet,
daß die Belichtung der lichtempfindlichen Schicht (207; 307; 407) mittels weicher Röntgenstrahlung im Wellenlängenbereich zwischen etwa 2 und 100 Å erfolgt.

9. Verfahren nach einem der Ansprüche 6 oder 8,
dadurch gekennzeichnet,
daß als lichtempfindliche Schicht (307) ein Photonegativ-Lack verwendet wird, wobei die zweite Absorberstruktur (303) nach der Entwicklung der lichtempfindlichen Schicht (307) galvanisch aufgebracht und anschließend die entwickelte lichtempfindliche Schicht (307) vollständig entfernt wird.

10. Verfahren nach einem der Ansprüche 6 oder 8, dadurch gekennzeichnet, daß als lichtempfindliche Schicht (207) ein Photonegativ-Lack verwendet wird, wobei eine Absorberschicht (201) nach der Entwicklung der lichtempfindlichen Schicht (207) durch Aufdampfen oder Aufsputtern aufgebracht und anschließend die entwickelte lichtempfindliche Schicht (207) zusammen mit dem darauf befindlichen Teil der Absorberschicht (210) entfernt wird, so daß nur die entsprechende Absorberstruktur (203) stehen bleibt.

11. Verfahren nach einem der Ansprüche 7 oder 8, dadurch gekennzeichnet, daß als lichtempfindliche Schicht (407) ein Photopositiv-Lack verwendet wird, wobei ein Teil der durchgehenden Absorberschicht (411) nach der Entwicklung der lichtempfindlichen Schicht (407) in Ätztechnik entfernt und anschließend die entwickelte lichtempfindliche Schicht entfernt wird, so daß nur die entsprechende Absorberstruktur (403) stehen bleibt.

**FIG.1**

**FIG.2**

a)

b)

c)

d)

e)

f)

FIG.3

a)

b)

c)

d)

e)

f)

FIG.4

a)

b)

c)

d)

e)

f)

g)